# EUROPEAN PATENT SPECIFICATION

(11) **EP 3 678 143 B1**
(45) Date of publication and mention of the grant of the patent: **16.08.2023**
(21) Application number: 19863982.5
(22) Date of filing: 22.08.2019
(51) Int. Cl.: G16H 20/00, B21C 37/04, G01N 21/952

(54) **METHOD AND DEVICE FOR MANUFACTURING PLATED WIRE**
VERFAHREN UND VORRICHTUNG ZUR HERSTELLUNG EINES PLATTIERTEN DRAHTS
PROCÉDÉ ET DISPOSITIF POUR FABRIQUER UN FIL PLAQUÉ

(30) Priority: 01.10.2018 JP 2018186596
(43) Date of publication of application: 08.07.2020
(73) Proprietor: Sumitomo Electric Toyama Co., Ltd., Imizu-shi Toyama 934-8522 (JP)
(72) Inventor: TSUCHIDA, Hitoshi, Imizu-shi, Toyama 934-8522 (JP); KAMOGAWA, Dai, Imizu-shi, Toyama 934-8522 (JP); OMURA, Tadashi, Imizu-shi, Toyama 934-8522 (JP); NAKAGAWA, Toshitaka, Imizu-shi, Toyama 934-8522 (JP)
(74) Representative: Boult Wade Tennant LLP
(86) International application number: PCT/JP2019/032871
(87) International publication number: WO 2020/071002

(56) References cited:
- JP-A- H 105 848
- JP-A- H0 623 432
- JP-A- H08 141 640
- JP-A- S62 287 634
- JP-A- 2000 156 450
- JP-A- 2002 214 152
- JP-A- 2003 053 420
- JP-A- 2007 205 974
- JP-A- 2010 145 347
- JP-A- 2015 029 995
- JP-A- 2015 029 995
- JP-A- 2015 120 966
- US-A1- 2008 285 840
- US-A1- 2015 086 807
- US-A1- 2018 172 601
- US-B2- 10 041 888

## Description

### TECHNICAL FIELD

The present disclosure is related to a manufacturing method of a plated wire rod, and a manufacturing apparatus of a plated wire rod.

### BACKGROUND ART

Conventionally, a metal terminal is used to connect electrical components to each other. For example, a metal terminal is fixed to a resin base and is soldered to a printed circuit board as an electrical component to form a substrate connector, and the printed circuit board and a connector as the other electrical component provided at an end of an external electric wire are connected to each other; or a pair of printed circuit boards as the electrical components are connected to each other using a metal terminal as an inter-substrate connection terminal.

The metal terminal is manufactured by press-cutting a conductive metal plate, a surface of which is plated with metal, or by cutting a plated wire rod, which is a metal wire rod plated with metal, into a predetermined length. Such a metal terminal is disclosed in Japanese Patent Laying-Open No. 2004-303680 (PTL 1), for example.

In recent years, electrification of vehicles is being accelerated, and the number of circuits in an electrical appliance is on the increase. Accordingly, multiplication of terminals are becoming more and more advanced. The insertion force at the time of assembly is increased in proportion to the number of terminals, and thus, the challenge is to suppress an increase in the workload and to stably maintain the connection.

For example, with respect to a material of a removable metal terminal, the coefficient of friction is reduced by forming, on an outermost layer of a conductive material, a metal plating layer or an alloy layer containing metal, or by further specifying the degree of exposure of the alloy layer (for example, see Japanese Patent Laying-Open No. 2003-147579 (PTL 2)).

Moreover, as a manufacturing method of a metal square wire-connector terminal, there is also known a method that uses a plated wire rod that is formed by applying metal plating to a conductive metal that is molded by a die, a roller or the like, and then performing die-drawing after heat treatment (for example, see Japanese Patent Laying-Open No. 2015-120966 (PTL 3)). US2015086807A1 relates to an isothermal processed copper cladded aluminum composite.

### CITATION LIST

### PATENT LITERATURE

PTL 1: Japanese Patent Laying-Open No. 2004-303680
PTL 2: Japanese Patent Laying-Open No. 2003-147579
PTL 3: Japanese Patent Laying-Open No. 2015-120966

### SUMMARY OF INVENTION

A manufacturing method of a plated wire rod according to a mode of the present disclosure is according to claim 1.

Additionally, in the present disclosure, skin-passing refers to rolling or drawing of the plated wire rod precursor.

A manufacturing apparatus of a plated wire rod according to a mode of the present disclosure is according to claim 8.

### BRIEF DESCRIPTION OF DRAWINGS

Fig. 1 is a schematic diagram showing an example of a manufacturing apparatus of a plated wire rod according to an embodiment of the present disclosure.
Fig. 2 is a schematic diagram showing an example structure of the plated wire rod.
Fig. 3 is a schematic diagram showing an example of a defect occurring in a plated wire rod-intermediate body.
Fig. 4 is a schematic diagram showing another example of the defect occurring in the plated wire rod-intermediate body.

### DETAILED DESCRIPTION

### [Problem to be Solved by the Present Disclosure]

To cause a high current to flow through a metal terminal, it is important to increase the diameter of the metal terminal and to secure contact with another member. In the case of a metal terminal that uses a plated wire rod that is formed by applying metal plating to the surface of a metal base material, defects such as scratches on the base material or failed plating of metal plating may result in increased contact resistance of the metal terminal. Furthermore, if, after heat treatment, die-drawing is performed on the plated wire rod, the surface of the metal base material of which is plated with metal, metal plating is possibly scratched or peeled off.

In view of the circumstances described above, the present disclosure has its object to provide a manufacturing method of a plated wire rod with few defects by highly accurately detecting, for a plated wire rod that is formed by applying metal plating to the surface of a metal base material, defects present on an interface between the base material and the metal plating and on the surface of the metal plating, and a manufacturing apparatus of a plated wire rod capable of performing the method.

### [Advantageous Effect of the Present Disclosure]

According to the present disclosure, there may be provided a manufacturing method of a plated wire rod with few defects by highly accurately detecting, for a plated wire rod that is formed by applying metal plating to the surface of a metal base material, defects present on an interface between the base material and the metal plating and on the surface of the metal plating, and a manufacturing apparatus of a plated wire rod capable of performing the method.

### [Description of Embodiments]

First, modes of the present disclosure will be enumerated.
(1) A manufacturing method of a plated wire rod according to a mode of the present disclosure is according to claim 1.
   According to the mode described in (1) above, there may be provided a manufacturing method of a plated wire rod with few defects by highly accurately detecting, for a plated wire rod that is formed by applying metal plating (a plating film) of second metal to the surface of a base material of first metal, defects present on an interface between the base material and the metal plating or on the surface of the metal plating.
   Defects that can be detected by the manufacturing method of a plated wire rod according to the embodiment of the present disclosure include not only parts where the metal plating is peeled off, but also scratches on the surface of the metal plating where the base material is not exposed.
(2) In the manufacturing method of a plated wire rod described in (1) above, preferably,
   the camera inspection device includes
      a light source that radiates light on a surface of the plated wire rod-intermediate body, and
      an imaging mechanism that detects reflected light that is the light from the light source reflected by the surface of the plated wire rod-intermediate body, and
   images of a plurality of color components are extracted from an image captured by the imaging mechanism, and the defect in the plated wire rod-intermediate body is detected on a basis of an amount of difference in luminance between images of the plurality of color components.

   According to the mode described in (2) above, a defect due to peeling-off of the plating film from the surface of the plated wire rod may be detected with high accuracy.
(3) In the manufacturing method of a plated wire rod described in (2) above, the image of the plurality of color components that is extracted from the image captured is preferably a color image or a monochrome image.
   According to the mode described in (3) above, a defect due to peeling-off of the plating film from the surface of the plated wire rod over a large area, or a defect due to peeling-off of the plating film over a small area may be detected depending on the purpose.
(4) In the manufacturing method of a plated wire rod described in (2) or (3) above, the plurality of color components that are extracted from the image captured are preferably two or more among three components of red, blue and green.
   According to the mode described in (4) above, by extracting an image using three primary colors of red, blue and green, a common device is allowed to be used, and simplification of a device is made possible.
(5) In the manufacturing method of a plated wire rod described in any one of (2) to (4) above, the light source is preferably a bar light (a line light).
   According to the mode described in (5), occurrence of color unevenness due to the light source may be suppressed, and erroneous detection of defects may be inhibited.
   Additionally, the bar light refers to a light where light emitting elements are linearly arranged and that performs surface light emission.
(6) In the manufacturing method of a plated wire rod described in any one of (2) to (5) above, the light source is preferably a white LED.
   According to the mode described in (6) above, because the light source includes all visible light, binarization by which brightness is made the same for all colors is enabled.
(7) In the manufacturing method of a plated wire rod described in any one of (1) to (6) above, preferably,
   a cross-section of the plated wire rod-intermediate body is quadrangular, and
   the camera inspection device simultaneously inspects, using a mirror, for presence/absence of a defect for at least a pair of facing surfaces of the plated wire rod-intermediate body.

   According to the mode described in (7) above, presence/absence of a defect may be inspected by one measurement, for at least a pair of facing surfaces of the plated wire rod.
(8) A manufacturing apparatus of a plated wire rod according to a mode of the present disclosure is according to claim 8.

According to the mode described in (8) above, there may be provided a manufacturing apparatus of a plated wire rod capable of performing the manufacturing method of a plated wire rod with few defects by highly accurately detecting, for a plated wire rod that is formed by applying metal plating to the surface of a base material, defects present on an interface between the base material and the metal plating or on the surface of the metal plating.

### [Details of Modes of Present Disclosure]

Specific examples of the manufacturing method of a plated wire rod and the manufacturing apparatus of the plated wire rod according to the modes of the present disclosure will be described below in greater detail. Additionally, the present invention is not limited to the examples, but is defined by the appended claims and is intended to include all modifications within the scope and meaning equivalent to those of the claims.

### <Manufacturing Method of Plated Wire Rod>

The manufacturing method of a plated wire rod according to an embodiment of the present disclosure includes a step of preparing a plated wire rod precursor (a preparation step), a step of obtaining a plated wire rod-intermediate body by performing skin-passing on the plated wire rod precursor (a processing step), and a step of inspecting, after the skin-passing, for presence/absence of a defect in the plated wire rod-intermediate body (an inspection step). Details of each step will be described below.

### (Preparation Step)

The preparation step is a step of preparing a plated wire rod precursor including a conductive metal base material that is wire-drawn and that has a linear shape (hereinafter simply referred to as "base material") and a plating film provided on a surface of the base material. In the present embodiment, the base material is made of first metal. Furthermore, the plating film is made of second metal of a different composition from the first metal.

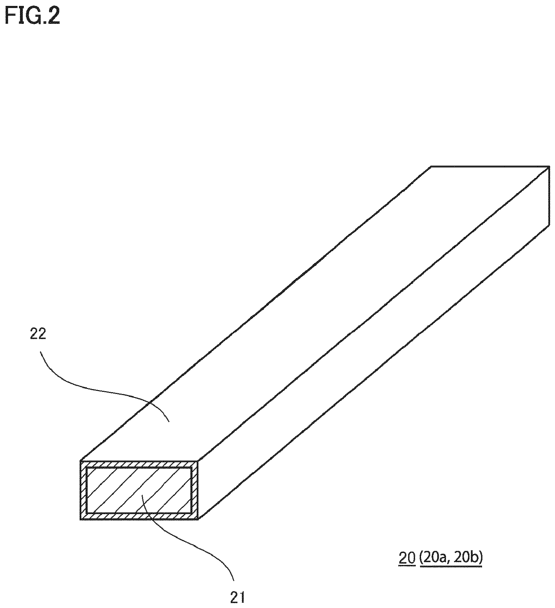

Fig. 2 shows a schematic diagram of a structure of a plated wire rod 20. In an aspect of the present embodiment, Fig. 2 may be assumed to be a schematic diagram of a structure of a plated wire rod precursor 20a, or may be assumed to be a schematic diagram of a structure of a plated wire rod-intermediate body 20b described later. Plated wire rod 20 is not limited with respect to a cross-sectional shape as long as plated wire rod 20 is wire-drawn and has a linear shape. For example, the cross-sectional shape of plated wire rod 20 may be a circle, an oval, a square, a rectangle, or a square or a rectangle with rounded corners. Furthermore, it is sufficient if plated wire rod 20 includes a plating film 22 on a surface of a base material 21 that is wire-drawn and that has a linear shape, where plating film 22 is made of the second metal different from the first metal forming base material 21.

Additionally, plating film 22 is formed around an entire circumference of base material 21. Furthermore, there may be provided a plurality of layers of plating film 22, instead of one layer of the same.

The first metal forming base material 21 may be a simple metal or an alloy, and for example, copper, tough-pitch copper, copper alloys (brass and the like), iron, iron alloys, aluminum, aluminum alloys and the like may be cited as the first metal.

The second metal forming plating film 22 may be a simple metal or an alloy, and copper, nickel, tin, silver, gold and the like may be cited as the second metal.

Considering that plated wire rod 20 that is obtained by the manufacturing method of a plated wire rod according to the embodiment of the present disclosure is to be used as a metal terminal, the first metal forming base material 21 is preferably copper or a copper alloy, and the second metal forming plating film 22 is preferably tin, from the standpoint of contact resistance, contact reliability, durability, solderability, economic performance and the like. Furthermore, plating film 22 may also preferably include an underlying plating film of copper, nickel or the like, and a plating film of tin or an alloy containing tin as the main element may be formed on a surface of the underlying plating film. Furthermore, plated wire rod 20 may be annealed.

A cross-sectional dimension of the plated wire rod is not particularly specified, and may be adjusted to a desired dimension. A thickness of plating film 22 is also not limited, and may be selected as appropriate.

### (Processing Step)

The processing step is a step of performing skin-passing on the plated wire rod precursor that is prepared in the preparation step. Skin-passing may be performed using a die. A plated wire rod-intermediate body may be obtained by performing the processing step.

The shape of a surface of the plated wire rod-intermediate body may be processed into a desired shape by performing skin-passing on the plated wire rod precursor. For example, even in a case of a plated wire rod precursor having a flat base material, and having a plating film of a relatively non-uniform thickness formed on the surface of the base material, a plated wire rod-intermediate body with a plating film having a uniform and thin thickness may be obtained by performing skin-passing using a die.

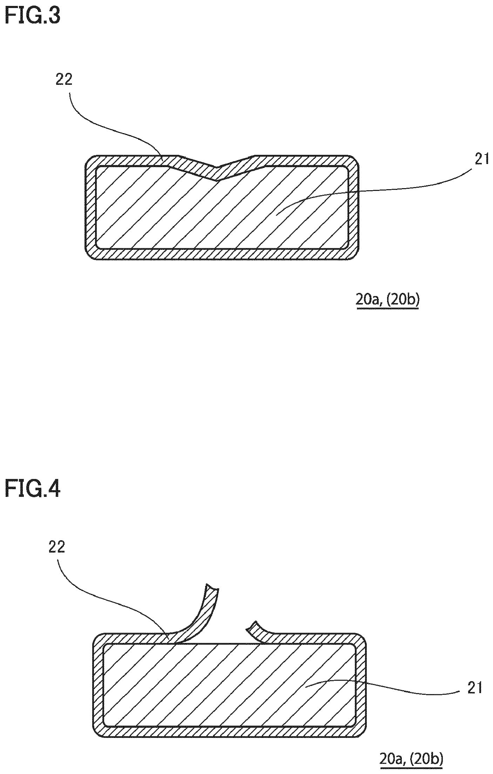

However, in skin-passing, a relatively large force is applied to a processing target object. Accordingly, if skin-passing is performed on plated wire rod precursor 20a, plating film 22 on the surface of plated wire rod-intermediate body 20b is possibly scratched and dented (see Fig. 3), or peeling-off is possibly caused at an interface between base material 21 and plating film 22 (see Fig. 4). If plated wire rod-intermediate body 20b with plating film 22 including a defect such as a scratch or peeling-off is processed into and used as a metal terminal, contact between the metal terminal and another connection member becomes poor, and contact resistance is increased. Accordingly, the part of the plated wire rod-intermediate body where a defect is present has to be removed in a manufacturing process of the plated wire rod.

In the manufacturing method of a plated wire rod according to the embodiment of the present disclosure, presence/absence of a defect in plated wire rod-intermediate body 20b is inspected in the inspection step, and also, removal of the defect in the plated wire rod-intermediate body is performed in the removal step that is subsequently performed.

Additionally, generally, a plated wire rod precursor may include, even before skin-passing, a failed plating portion where an adhesive force of the plating film on the surface of the base material is low. Such a failed plating portion may become evident in the form of a defect when the plating film is peeled off at a time when the plated wire rod precursor is wound around the reel, for example. Furthermore, even if the defective plating portion does not become evident in the form of a defect, the failed plating portion has to be removed because, when the plated wire rod is processed into and used as a metal terminal, the failed plating portion causes an increase in the contact resistance between the metal terminal and another connection member. However, the defective plating portion is difficult to detect simply by observing the plated wire rod-intermediate body from outside.

In the manufacturing method of a plated wire rod according to the embodiment of the present disclosure, skin-passing performed in the processing step serves the role of a stress test, and may cause the failed plating portion that is latent in the plated wire rod-intermediate body to be made evident in the form of a defect. That is, when skin-passing is performed, the plating film is peeled off at the failed plating portion, and the failed plating portion becomes detectable as an external defect.

### (Inspection Step)

The inspection step is a step performed immediately after skin-passing, of inspecting for presence/absence of a defect in the plated wire rod-intermediate body using an eddy current testing device and a camera inspection device. According to an aspect of the present embodiment, the order of inspection using the eddy current testing device and inspection using the camera inspection device is not particularly specified. The inspection using the eddy current testing device may be performed first, or the inspection using the camera inspection device may be performed first.

### - Eddy Current Testing Device -

By performing inspection of the plated wire rod-intermediate body using the eddy current testing device, step-shaped defects such as scratches formed on the surface of plated wire rod-intermediate body 20b as shown in Fig. 3 and impurities deposited on the surface of plating film 22 may be mainly detected. Any conventionally known eddy current testing device may be used.

Generally, when an inspection target object sways while inspection is being performed by the eddy current testing device, a scratch is erroneously determined to be present on the inspection target object. In the case of an inspection target object for which wire shaking tends to occur at the time of transfer, such as the plated wire rod-intermediate body, noise which leads to erroneous determination of a scratch is easily caused.

In the manufacturing method of a plated wire rod according to the embodiment of the present disclosure, because skin-passing is performed on the plated wire rod precursor immediately before inspection by the eddy current testing device, the plated wire rod-intermediate body is firmly fixed by a die. Accordingly, wire shaking of the plated wire rod-intermediate body is not easily caused, and inspection by the eddy current testing device may be performed with higher accuracy.

### - Camera Inspection Device -

By performing inspection of the plated wire rod-intermediate body using the camera inspection device, peeling-off of plating film 22 from the surface of plated wire rod-intermediate body 20b as shown in Fig. 4 may be mainly detected.

Base material 21 is exposed to the surface of plated wire rod-intermediate body 20b, at a part where plating film 22 is peeled off. Because wavelengths of light reflected by base material 21 and plating film 22 are different, presence/absence of a defect due to peeling-off of plating film 22 may be determined by radiating light on plated wire rod-intermediate body 20b and analyzing components of reflected light.

Specifically, first, light is radiated on the surface of plated wire rod-intermediate body 20b using an appropriate light source. Then, reflected light reflected by the surface of the plated wire rod-intermediate body is detected by an imaging mechanism. The imaging mechanism extracts an image of a plurality of color components from a captured image, and may inspect for presence/absence of a defect on the surface of the plated wire rod-intermediate body on the basis of an amount of difference in luminance between images of the plurality of color components.

The image of the plurality of color components extracted from the captured image may be a color image or a monochrome image. Furthermore, it is also possible to extract a plurality of color images and perform comparison on the basis of the amount of difference in luminance between the images of the plurality of color components, and also, to convert a color image into a monochrome (gray or binarized) image and perform a detection process. In the case of performing the detection process by converting the captured image into a monochrome image, the detection process may be performed by performing conversion into a gray image (a monochrome image) by extracting only brightness from the color image.

In the case of extracting a plurality of color images and performing the detection process on the basis of the amount of difference in luminance between the images of the plurality of color components (color inspection), peeling-off of plating film 22 over a relatively large area (an area with a diameter of 0.20 mm or more) may be detected.

Furthermore, in the case of converting a color image into a monochrome image and performing the detection process, peeling-off of plating film 22 over a relatively small area (an area with a diameter of 0.15 mm or more) may also be detected.

The plurality of color components that are extracted from the captured color image are preferably two or more among three components of red, green and blue, for example. In the case of extracting two or more among three primary colors of red, green and blue, a common device is allowed to be used, and simplification of a device is made possible. With respect to color comparison of red, green and blue in images, comparison and detection process are performed on a per-segment basis for each of hue, brightness and saturation. Moreover, in the case of performing processing using only two components, processing may be performed at a higher speed than in the case of performing processing using three components.

Additionally, in the inspection of the surface of plated wire rod-intermediate body 20b, imaging may be performed by dividing a field of view in a planar direction into several parts (such as a center portion, corner portions and the like). Furthermore, in the case of performing imaging by dividing the field of view in the planar direction on the surface of plated wire rod-intermediate body 20b, different processes may be performed on respective images (for example, the process based on a color image and the process based on a monochrome image described above).

The light source may be any light source as long as light can be radiated on the plated wire rod-intermediate body, and a coaxial epi-illumination or a bar light (a line light) may be used, for example.

The coaxial epi-illumination vertically radiates light toward the plated wire rod-intermediate body from the direction of a lens, and radiated light is vertically reflected by the surface of the plated wire rod-intermediate body and travels straight to the lens. For example, the coaxial epi-illumination may be made by using a semitransparent mirror as the lens.

If the coaxial epi-illumination is used in a case where the plated wire rod-intermediate body has a wide, flat shape as shown in Fig. 2, for example, it is difficult to uniformly radiate light on the surface of the plated wire rod-intermediate body, and color unevenness is possibly caused. Furthermore, specularly reflected light that is vertically reflected from the surface of the plated wire rod-intermediate body possibly causes halation.

Even in the case where the plated wire rod-intermediate body has a wide, flat shape, light may be uniformly radiated on the surface of the plated wire rod-intermediate body by using a bar light (a line light) as the light source. In the case of using a bar light as the light source, the bar light may be disposed such that light is obliquely radiated on the surface of the plated wire rod-intermediate body so that the specularly reflected light that causes halation is not generated. Then, diffusely reflected light may be detected and imaged, and presence/absence of a defect may be determined.

Furthermore, by capturing the specularly reflected light by tilting the camera at a same angle as the bar light, an edge component may be made to stand out.

As the light source, a white light emitting diode (LED) is preferably used. Because white light includes all visible light, all colors may be grayscaled (binarized) with the same level of lightness if the lightness (brightness) of the colors are the same. When the white LED is used in the case where the color of the plated wire rod-intermediate body includes multiple colors, a singular point may be captured without being affected by the colors.

In the case where the cross-section of the plated wire rod-intermediate body is a flat quadrangular shape, the camera inspection device preferably simultaneously inspects, using a mirror, for presence/absence of a defect for at least a pair of facing surfaces of the plated wire rod-intermediate body. In the present embodiment, a "quadrangle" is a concept including a substantially quadrangular shape without being limited to a geometric quadrangle. For example, a shape formed from a square or a rectangle by modifying its corners into arc shape are also included as the "quadrangle" described above. By simultaneously inspecting both of upper and lower surfaces of the plated wire rod-intermediate body using a mirror, an inspection time may be reduced, or a device configuration may be simplified. Furthermore, when a mirror is arranged to enable simultaneous inspection of both of left and right surfaces, in addition to the upper and lower surfaces, entire circumference of the plated wire rod-intermediate body may be simultaneously inspected.

### (Removal Step)

The removal step is a step of removing a defect in the plated wire rod-intermediate body detected in the inspection step. When the removal step is performed, a plated wire rod as a finished product is obtained from the plated wire rod-intermediate body. A plated wire rod from which a metal terminal with small contact resistance to another member can be manufactured can be manufactured by removing a defect in the plated wire rod-intermediate body. The method of removing a defect in the plated wire rod-intermediate body is not particularly specified, and for example, a defective portion may be cut and removed by a cutter, a knife and the like.

Furthermore, plated wire rod-intermediate bodies that are cut may be connected by welding or the like after a defective portion is removed, or the plated wire rod-intermediate bodies may be wound around separate reels without being connected after the defective portion is removed. Furthermore, removal of a defect does not have to be performed immediately after the defect is detected, and a defective portion may be marked, and the defective portion may be cut and removed by detecting the defect at a desired stage, by performing image processing again, for example.

The plated wire rod that is obtained by the manufacturing method of a plated wire rod according to the embodiment of the present disclosure may be used for various uses other than a terminal for a connector, such as a conductor of an electric wire, a material for a spring, a wiring material for a communication appliance, a wiring material for a measurement appliance, a plated flat wire for a solar panel, a contact terminal, a connector, a relay, a chip component, an automotive electrical equipment, a component for a digital household appliance, an electronic component and the like.

### <Manufacturing Apparatus of Plated Wire Rod>

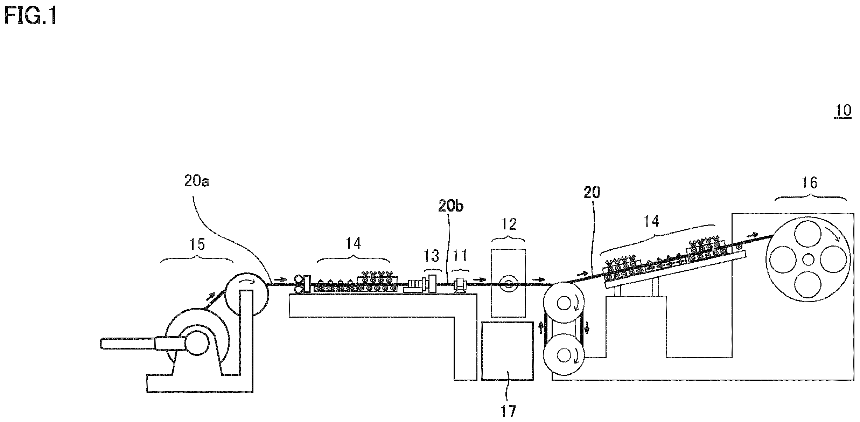

An example structure of the manufacturing apparatus of a plated wire rod according to the embodiment of the present disclosure is schematically shown in Fig. 1.

As shown in Fig. 1, a manufacturing apparatus 10 of a plated wire rod according to the embodiment of the present disclosure includes a supply unit 15 that draws out plated wire rod precursor 20a from a reel around which plated wire rod precursor 20a is wound, a processing unit 13 that obtains plated wire rod-intermediate body 20b by performing skin-passing on plated wire rod precursor 20a, an inspection unit arranged immediately after the processing unit 13 that inspects for presence/absence of a defect in plated wire rod-intermediate body 20b using an eddy current testing device 11 and a camera inspection device 12 immediately after skin-passing has been performed and whilst the plated wire rod-intermediate body 20b is firmly fixed by the die, and a removal mechanism 17 that obtains plated wire rod 20 by removing the defect in plated wire rod-intermediate body 20b. According to an aspect of the present embodiment, the order of arrangement of eddy current testing device 11 and camera inspection device 12 is not particularly specified. Eddy current testing device 11 may be arranged in front, or camera inspection device 12 may be arranged in front.

It is sufficient if plated wire rod precursor 20a that is wound around a reel is prepared by the preparation step described in relation to the manufacturing method of a plated wire rod according to the embodiment of the present disclosure described above. Plated wire rod precursor 20a that is drawn out from supply unit 15 is sometimes fixed in a curved state, and thus, it is preferably straightened into a straight shape by a straightening roller unit 14.

Processing unit 13 that obtains plated wire rod-intermediate body 20b by performing skin-passing on plated wire rod precursor 20a may be configured such that processing unit 13 is capable of processing plated wire rod precursor 20a into a desired shape using a die such as a diamond die, as described above with respect to the processing step.

Eddy current testing device 11 and camera inspection device 12 positioned on a downstream side of processing unit 13 may be configured in the same manner as those described in relation to the manufacturing method of a plated wire rod according to the embodiment of the present disclosure described above. Various defects on plated wire rod-intermediate body 20b may be detected by eddy current testing device 11 and camera inspection device 12.

Manufacturing apparatus 10 of a plated wire rod according to the embodiment of the present disclosure includes removal mechanism 17 that is capable of removing various defects on plated wire rod-intermediate body 20b detected by eddy current testing device 11 and camera inspection device 12. It is sufficient if removal mechanism 17 is configured to be capable of removing defects in plated wire rod-intermediate body 20b, and removal mechanism 17 may be a cutter, a knife and the like, for example.

Plated wire rod 20 from which a defective portion is cut and removed by removal mechanism 17 passes through straightening roller unit 14 again and is wound around a reel by a winding unit 16. Additionally, after the defective portion is cut, plated wire rods 20 may be connected by welding or the like, or may be wound around separate reels without being connected.

### Examples

Hereinafter, the present invention will be described in greater detail with reference to examples, but the examples are merely exemplary, and the manufacturing method and the like of a plated wire rod according to the present invention are not limited to the examples. The scope of the present invention is defined by the appended claims and is intended to include all modifications within the scope of the claims.

### (Example 1)

### - Preparation Step -

A flat wire rod of tough-pitch copper of 0.65 mm × 1.05 mm that was molded by a die was used as a base material. A plated wire rod precursor was fabricated by applying underlying plating of copper on the surface of the base material, applying a tin plating after the underlying plating, and thus forming a plating film.

A copper (Cu) plating film of 1 µm was formed under plating conditions for copper plating of copper sulfate bath (copper sulfate 250g/L, sulfuric acid 40g/L), a liquid temperature of 25°C, and a current density of 5 A/dm².

A tin (Sn) plating film of 1.3 µm was formed under plating conditions for tin plating of tin sulfate bath (tin sulfate 80g/L, sulfuric acid 80g/L, additive agent 10g/L), a liquid temperature of 25°C, and a current density of 5 A/dm².

A plated wire rod was fabricated using manufacturing apparatus 10 of a plated wire rod shown in Fig. 1.

### - Processing Step -

A reflow process was performed on a plated wire rod precursor prepared in the preparation step described above at 250°C for 3 minutes. Then, skin-passing was performed on the plated wire rod precursor using a diamond die, and the wire rod precursor was drawn to 0.64 mm × 1.5 mm. That is, a plated wire rod-intermediate body was obtained from the plated wire rod precursor by performing the processing step.

### - Inspection Step -

Subsequent to skin-passing, presence/absence of scratches formed on the surface of the plated wire rod-intermediate body and of impurities deposited on the surface of the plated wire rod-intermediate body was inspected using the eddy current testing device.

Subsequent to the inspection by the eddy current testing device, inspection was performed using the camera inspection device, for presence/absence of peeling-off of the plating film from the surface of the plated wire rod-intermediate body. Observation of the surface of the plated wire rod-intermediate body was performed by dividing the field of view on the surface of the plated wire rod-intermediate body into a center portion and corner portions at both ends. A coaxial epi-illumination of white LED was used as the light source of the camera inspection device. Then, specularly reflected light was detected and imaged by the imaging mechanism. Furthermore, presence/absence of a defect was inspected using a mirror, simultaneously for both of an upper surface and a lower surface of the plated wire rod-intermediate body.

Extracting a red component and a blue component from an image captured by the imaging mechanism and performing comparison on the basis of the amount of difference in luminance between images of the color components, and converting a color image into a monochrome (gray or binarized) image and performing a detection process were both performed.

### - Removal Step -

A defective portion such as a scratch or peeling-off of the plating film on the plated wire rod-intermediate body detected in the inspection step was cut and removed by a cutter, and a plated wire rod No. 1 from which the defective portion was removed was obtained.

### (Example 2)

A plated wire rod No. 2 was fabricated in the same manner as in Example 1, except that the light source of the camera inspection device in the inspection step in Example 1 was configured as follows.

A bar light of white LED was used as the light source of the camera inspection device, and light was obliquely radiated on the surface of the plated wire rod-intermediate body. Then, diffusely reflected light was detected and imaged by the imaging mechanism.

### (Comparative Example 1)

A plated wire rod No. 3 was fabricated in the same manner as in Example 1, except that the processing step in Example 1 was not performed, and only inspection by the eddy current testing device was performed in the inspection step and inspection by the camera inspection device was not performed.

### (Comparative Example 2)

A plated wire rod No. 4 was fabricated in the same manner as in Example 1, except that only inspection by the eddy current testing device was performed in the inspection step in Example 1 and inspection by the camera inspection device was not performed.

### (Comparative Example 3)

A plated wire rod No. 5 was fabricated in the same manner as in Example 1, except that the processing step in Example 1 was not performed.

### (Comparative Example 4)

A plated wire rod No. 6 was fabricated in the same manner as in Example 2, except that the processing step in Example 2 was not performed.

### <Evaluation Result>

Types of defects that were able to be detected in the process of fabricating plated wire rods Nos. 1 to 6 are summarized in Table 1.

**[Table 1]**

| Plated Wire Rod No. | Type (Size) of Defect | | | | | | | |
|---|---|---|---|---|---|---|---|---|
| | Failed Plating 1 (>100 µm) | Failed Plating 2 (>100 µm) | Streak (<1 µm) | Dent/Scratch 1 (5 µm) | Dent/Scratch 2 (30 µm) | Foreign Matter Deposition 1 (30 µm) | Foreign Matter Deposition 2 (30 µm) | Fogging (5 µm) |
| 1 | Detected | Detected | Detected | Detected | Detected | Detected | Detected | Detected |
| 2 | Detected | Detected | Detected | Detected | Detected | Detected | Detected | Detected |
| 3 | Non-Detectable | Non-Detectable | Non-Detectable | Non-Detectable | Detected | Detected | Detected | Detected |
| 4 | Detected | Detected | Non-Detectable | Non-Detectable | Detected | Detected | Detected | Detected |
| 5 | Non-Detectable | Detected | Detected | Detected | Detected | Non-Detectable | Detected | Non-Detectable |
| 6 | Non-Detectable | Detected | Detected | Detected | Detected | Non-Detectable | Detected | Non-Detectable |

Details of the types of defects shown in Table 1 are as follows.

### - Failed Plating 1

A state where adhesion between plating film 22 and base material 21 is poor, and base material 21 is exposed when plated wire rod 20 is bent.

### - Failed Plating 2

A state where plating film 22 is not formed, and base material 21 is exposed.

### - Streak

A state where a thin, line-shaped dent (of a thickness equal to or smaller than that of plating film 22) is present on the surface of plating film 22.

### - Dent/Scratch 1

A state where a dent or a scratch is present on the surface of plating film 22.

### - Dent/Scratch 2

A state where a dent or a scratch is present on the surface of plating film 22.

### - Foreign Matter Deposition 1

A state where plating residue is deposited on the surface of plating film 22 (a case where a deposited matter is of a same color as plating film 22).

### - Foreign Matter Deposition 2

A state where a matter of a different plating color is deposited on the surface of plating film 22.

### - Fogging

Copper fogging on base material 21 (a state where crack is present on base material 21, and a plating film is formed on the surface of the crack).

As shown in Table 1, with the manufacturing methods of plated wire rods in Example 1 and Example 2, all types of defects on plated wire rod 20 (plated wire rod-intermediate body 20b) were able to be detected, and a high-quality plated wire rod with few defects was obtained by removing the defects.

### REFERENCE SIGNS LIST

10 manufacturing apparatus of plated wire rod, 11 eddy current testing device, 12 camera inspection device, 13 processing unit, 14 straightening roller unit, 15 supply unit, 16 winding unit, 17 removal mechanism, 20 plated wire rod, 20a plated wire rod precursor, 20b plated wire rod-intermediate body, 21 base material, 22 plating film

## Claims

1. A manufacturing method of a plated wire rod (20), the method comprising:
preparing a plated wire rod precursor (20a) including a base material (21) that is wire-drawn and that has a linear shape and a plating film (22) that is provided on a surface of the base material (21), where the base material (21) is made of first metal and the plating film (22) is made of second metal of a different composition from the first metal;
obtaining a plated wire rod-intermediate body (20b) by performing skin-passing on the plated wire rod precursor (20a) using a die;
inspecting, immediately after the skin-passing, for presence/absence of a defect in the plated wire rod-intermediate body (20b) using an eddy current testing device (11) and a camera inspection device (12), the plated wire rod-intermediate body (20b) being firmly fixed by the die; and
obtaining a plated wire rod (20) by removing the defect in the plated wire rod-intermediate body (20b) that is detected in the inspecting.

2. The manufacturing method of a plated wire rod (20) according to claim 1, wherein
the camera inspection device (12) includes
a light source that radiates light on a surface of the plated wire rod-intermediate body (20b), and
an imaging mechanism that detects reflected light that is the light from the light source reflected by the surface of the plated wire rod-intermediate body (20b), and
images of a plurality of color components are extracted from an image captured by the imaging mechanism, and the defect in the plated wire rod-intermediate body (20b) is detected on a basis of an amount of difference in luminance between images of the plurality of color components.

3. The manufacturing method of a plated wire rod (20) according to claim 2, wherein the image of the plurality of color components that is extracted from the image captured is a color image or a monochrome image.

4. The manufacturing method of a plated wire rod (20) according to claim 2 or 3, wherein the plurality of color components that are extracted from the image captured are two or more among three components of red, blue and green.

5. The manufacturing method of a plated wire rod (20) according to any one of claims 2 to 4, wherein the light source is a bar light.

6. The manufacturing method of a plated wire rod (20) according to any one of claims 2 to 5, wherein the light source is a white LED.

7. The manufacturing method of a plated wire rod (20) according to any one of claims 1 to 6, wherein
a cross-section of the plated wire rod-intermediate body (20b) is quadrangular, and
the camera inspection device (12) simultaneously inspects, using a mirror, for presence/absence of a defect for at least a pair of facing surfaces of the plated wire rod-intermediate body (20b).

8. A manufacturing apparatus (10) configured to manufacture a plated wire rod (20), the apparatus (10) comprising:
a supply unit (15) comprising means for drawing out a plated wire rod precursor (20a) from a reel around which the plated wire rod precursor (20a) is wound, the plated wire rod precursor (20a) including a base material (21) having a linear shape and a plating film (22) provided on a surface of the base material (21);
a processing unit (13) comprising a die for obtaining a plated wire rod-intermediate body (20b) by performing skin-passing on the plated wire rod precursor (20a);
an inspection unit arranged immediately after the processing unit (13) and comprising an eddy current testing device (11) and a camera inspection device (12) configured to inspect for presence/absence of a defect in the plated wire rod-intermediate body (20b) immediately after skin-passing has been performed and whilst the plated wire rod-intermediate body (20b) is firmly fixed by the die; and
a removal mechanism (17) comprising means for obtaining a plated wire rod (20) by removing the defect in the plated wire rod-intermediate body (20b).

## Patentansprüche

1. Herstellverfahren für einen beschichteten Walzdraht (20), wobei das Verfahren umfasst:
Vorbereiten eines Vorprodukts (20a) eines beschichteten Walzdrahts, umfassend ein Basismaterial (21), das ausgezogen wird und eine lineare Form aufweist, und einen Beschichtungsfilm (22), der auf einer Oberfläche des Basismaterials (21) angeordnet ist, wobei das Basismaterial (21) aus einem ersten Metall besteht und der Beschichtungsfilm (22) aus einem zweiten Metall mit einer anderen Zusammensetzung als das erste Metall besteht;
Erhalten eines Zwischenkörpers (20b) eines beschichteten Walzdrahts durch Durchführen eines Dressierwalzens am Vorprodukt (20a) des beschichteten Walzdrahts mit einem Werkzeug;
Prüfen auf Vorhandensein/Fehlen eines Fehlers im Zwischenkörper (20b) des beschichteten Walzdrahts unmittelbar nach dem Dressierwalzen mit einer Wirbelstrom-Prüfvorrichtung (11) und einer Kameraprüfvorrichtung (12), wobei der Zwischenkörper (20b) des beschichteten Walzdrahts fest durch das Werkzeug befestigt ist; und
Erhalten eines beschichteten Walzdrahts (20) durch Entfernen des Fehlers im Zwischenkörper (20b) des beschichteten Walzdrahts, der beim Prüfen erfasst wird.

2. Herstellverfahren für einen beschichteten Walzdraht (20) nach Anspruch 1, wobei
die Kameraprüfvorrichtung (12)
eine Lichtquelle, die Licht auf eine Fläche des Zwischenkörpers (20b) des beschichteten Walzdrahts strahlt, und
einen Bildgebungsmechanismus, der reflektiertes Licht erfasst, welches das von der Fläche des Zwischenkörpers (20b) des beschichteten Walzdrahts reflektierte Licht von der Lichtquelle ist, umfasst, und
Bilder einer Vielzahl von Farbkomponenten von einem vom Bildgebungsmechanismus erfassten Bild extrahiert werden und der Fehler im Zwischenkörper (20b) des beschichteten Walzdrahts auf einer Basis einer Menge des Unterschieds in der Luminanz zwischen Bildern der Vielzahl von Farbkomponenten erfasst wird.

3. Herstellverfahren für einen beschichteten Walzdraht (20) nach Anspruch 2, wobei das Bild der Vielzahl von Farbkomponenten, die aus dem erfassten Bild extrahiert werden, ein Farbbild oder ein Monochrombild ist.

4. Herstellverfahren für einen beschichteten Walzdraht (20) nach Anspruch 2 oder 3, wobei die Vielzahl von Farbkomponenten, die vom erfassten Bild extrahiert werden, zwei oder mehr von drei Komponenten von Rot, Blau und Grün sind.

5. Herstellverfahren für einen beschichteten Walzdraht (20) nach einem der Ansprüche 2 bis 4, wobei die Lichtquelle ein Stablicht ist.

6. Herstellverfahren für einen beschichteten Walzdraht (20) nach einem der Ansprüche 2 bis 5, wobei die Lichtquelle eine weiße LED ist.

7. Herstellverfahren für einen beschichteten Walzdraht (20) nach einem der Ansprüche 1 bis 6, wobei
ein Querschnitt des Zwischenkörpers (20b) des beschichteten Walzdrahts viereckig ist, und
die Kameraprüfvorrichtung (12) gleichzeitig mit einem Spiegel auf Vorhandensein/Fehlen eines Fehlers für wenigstens ein Paar von gegenüberliegenden Flächen des Zwischenkörpers (20b) des beschichteten Walzdrahts prüft.

8. Zum Herstellen eines beschichteten Walzdrahts (20) ausgebildete Herstellvorrichtung (10), wobei die Vorrichtung (10) umfasst:
eine Zuführeinheit (15), umfassend Mittel zum Ausziehen eines Vorprodukts (20a) des beschichteten Walzdrahts von einer Spule, um die das Vorprodukt (20a) des beschichteten Walzdrahts gewickelt ist, wobei das Vorprodukt (20a) des beschichteten Walzdrahts ein Basismaterial (21) mit einer linearen Form und einen auf einer Oberfläche des Basismaterials (21) angeordneten Beschichtungsfilm (22) umfasst;
eine Verarbeitungseinheit (13), umfassend ein Werkzeug zum Erhalten eines Zwischenkörpers (20b) eines beschichteten Walzdrahts durch Durchführen eines Dressierwalzens am Vorprodukt (20a) des beschichteten Walzdrahts;
eine unmittelbar nach der Verarbeitungseinheit (13) angeordnete Prüfeinheit, umfassend eine Wirbelstrom-Prüfvorrichtung (11) und eine Kameraprüfvorrichtung (12), ausgebildet zum Prüfen auf Vorhandensein/Fehlen eines Fehlers im Zwischenkörper (20b) des beschichteten Walzdrahts, unmittelbar nachdem ein Dressierwalzen durchgeführt wurde und während der Zwischenkörper (20b) fest durch das Werkzeug befestigt ist; und
einen Entfernungsmechanismus (17), umfassend Mittel zum Erhalten eines beschichteten Walzdrahts (20) durch Entfernen des Fehlers im Zwischenkörper (20b) des beschichteten Walzdrahts.

## Revendications

1. Procédé de fabrication d'un fil machine plaqué (20), le procédé comprenant :
la préparation d'un précurseur de fil machine plaqué (20a) incluant un matériau de base (21) qui est tréfilé et qui présente une forme linéaire et un film de placage (22) qui est fourni sur une surface du matériau de base (21), où le matériau de base (21) est constitué de premier métal et le film de placage (22) est constitué de second métal d'une composition différente du premier métal ;
l'obtention d'un corps intermédiaire de fil machine plaqué (20b) en réalisant un passage de peau sur le précurseur de fil machine plaqué (20a) en utilisant une filière ;
l'examen, immédiatement après le passage de peau, de présence/absence d'un défaut dans le corps intermédiaire de fil machine plaqué (20b) en utilisant un dispositif de test de courant de Foucault (11) et un dispositif d'examen par caméra (12), le corps intermédiaire de fil machine plaqué (20b) étant fermement fixé par la filière ; et
l'obtention d'un fil machine plaqué (20) en éliminant le défaut dans le corps intermédiaire de fil machine plaqué (20b) qui est détecté dans l'examen.

2. Procédé de fabrication d'un fil machine plaqué (20) selon la revendication 1, dans lequel
le dispositif d'examen par caméra (12) inclut
une source de lumière qui irradie de la lumière sur une surface du corps intermédiaire de fil machine plaqué (20b), et
un mécanisme d'imagerie qui détecte de la lumière réfléchie qui est la lumière de la source de lumière reflétée par la surface du corps intermédiaire de fil machine plaqué (20b), et
des images de plusieurs constituants de couleur sont extraites à partir d'une image capturée par le mécanisme d'imagerie, et le défaut dans le corps intermédiaire de fil machine plaqué (20b) est détecté sur une base d'une quantité de différence de luminance entre des images des plusieurs constituants de couleur.

3. Procédé de fabrication d'un fil machine plaqué (20) selon la revendication 2, dans lequel l'image des plusieurs constituants de couleur qui est extraite de l'image capturée est une image en couleur ou une image monochrome.

4. Procédé de fabrication d'un fil machine plaqué (20) selon la revendication 2 ou 3, dans lequel les plusieurs constituants de couleur qui sont extraits de l'image capturée sont deux ou plusieurs parmi trois constituants de rouge, bleu et vert.

5. Procédé de fabrication d'un fil machine plaqué (20) selon l'une quelconque des revendications 2 à 4, dans lequel la source de lumière est une lumière en barre.

6. Procédé de fabrication d'un fil machine plaqué (20) selon l'une quelconque des revendications 2 à 5, dans lequel la source de lumière est un LED blanc.

7. Procédé de fabrication d'un fil machine plaqué (20) selon l'une quelconque des revendications 1 à 6, dans lequel
une section transversale du corps intermédiaire de fil machine plaqué (20b) est quadrangulaire, et
le dispositif d'examen par caméra (12) examine simultanément, en utilisant un miroir, la présence/absence d'un défaut pour au moins une paire de surfaces se faisant face du corps intermédiaire de fil machine plaqué (20b).

8. Appareil de fabrication (10) configuré pour fabriquer un fil machine plaqué (20), l'appareil (10) comprenant :
une unité d'alimentation (15) comprenant un moyen pour étirer un précurseur de fil machine plaqué (20a) à l'extérieur d'une bobine autour de laquelle le précurseur de fil machine plaqué (20a) est enroulé, le précurseur de fil machine plaqué (20a) incluant un matériau de base (21) ayant une forme linéaire et un film de placage (22) fourni sur une surface du matériau de base (21) ;
une unité de traitement (13) comprenant une filière pour obtenir un corps intermédiaire de fil machine plaqué (20b) en réalisant un passage de peau sur le précurseur de fil machine plaqué (20a) ;
une unité d'examen disposée immédiatement après l'unité de traitement (13) et comprenant un dispositif de test de courant de Foucault (11) et un dispositif d'examen par caméra (12) configuré pour examiner la présence/absence d'un défaut dans le corps intermédiaire de fil machine plaqué (20b) immédiatement après que le passage de peau a été réalisé et alors que le corps intermédiaire de fil machine plaqué (20b) est fermement fixé par la filière ; et
un mécanisme d'élimination (17) comprenant un moyen pour obtenir un fil machine plaqué (20) par élimination du défaut dans le corps intermédiaire de fil machine plaqué (20b).
